Europäisches Patentamt

European Patent Office

Office européen des brevets

(11) Publication number: **0 345 048**
A2

(12) **EUROPEAN PATENT APPLICATION**

(21) Application number: **89305495.7**

(22) Date of filing: **31.05.89**

(51) Int. Cl.⁴: **H 01 L 27/16**

(30) Priority: **01.06.88 GB 8812954**

(43) Date of publication of application:
**06.12.89 Bulletin 89/49**

(84) Designated Contracting States:
**AT BE CH DE ES FR GB GR IT LI LU NL SE**

(71) Applicant: **THORN EMI plc**
**4 Tenterden Street**
**London W1A 2AY (GB)**

(72) Inventor: **Etienne, Stephen David**
**29, Willowtree Lane**
**Hayes Middlesex, UB4 9BD (GB)**

**Sibbald, Alastair**
**18, Horseguards Drive**
**Maidenhead Berkshire, SL6 1XL (GB)**

(74) Representative: **Fleming, Ian Alexander et al**
**THORN EMI Patents Limited The Quadrangle Westmount**
**Centre Uxbridge Road**
**Hayes Middlesex, UB4 0HB (GB)**

(54) **Thermal imaging device.**

(57) A thermal imaging device comprises an array of pyroelectric detector elements 3, 4, 5 supported on a dielectric membrane 2. Thermally insulating pillars 6 provide an electrical path between the detector elements 3, 4, 5 and an integrated circuit 7.

FIG.1

EP 0 345 048 A2

**Description**

## THERMAL IMAGING DEVICE

This invention relates to thermal imaging devices and in particular to thermal imaging devices comprising a pyroelectric array of pyroelectric detector elements responsive to infra-red radiation.

The main factor limiting the performance of existing pyroelectric imagers is the thermal conductance between adjacent detector elements and between each detector element and the supporting and interrogating structure.

British Patent Application No.2163596A discloses a thermal imaging device comprising a ferroelectric slab of lead zirconate titanate (LZT) bearing a common electrode on one main surface and a signal electrode structure on the other main surface. The signal electrode structure is electrically connected to electrodes of a circuit substrate by means of electrical conductors. The transverse heat conduction between adjacent conductors is reduced by incorporating each conductor on a bore in a respective pillar of thermally insulating material, the pillars also being effective to support the ferroelectric slab.

Such a device suffers the disadvantage however that fabrication of the device requires the ceramic fabrication and subsequent machining of the LZT slab, this being necessarily a slow and difficult process, as the LZT will be brittle. Furthermore there will be considerable thermal cross-talk between adjacent pyroelectric detector elements.

One object of the present invention is to provide an alternative construction of thermal imaging device having low thermal conductance from the detector elements.

Another object of the present invention is to use a thin film of pyroelectric material to provide low thermal conductance between the detector elements.

Another object of the present invention is to provide a form of thermal imaging device which is simple to manufacture

According to a first aspect of the present invention a thermal imaging device comprises: a thermally insulative dielectric layer; an array of discrete pyroelectric detector elements carried by the dielectric layer, each detector element comprising a region of pyroelectric material and first and second electrodes each carried on respective oppositely directed surfaces of the region; and means for transferring electrical signals between the detector elements and a signal processing means.

The pyroelectric material in the device may comprise material which is inherently pyroelectric, or material whose pyroelectric characteristics are induced (e.g. by appropriate poling of ferroelectric material).

The regions of pyroelectric material are preferably in the form of thin films.

Each region of pyroelectric material may be distinct from the dielectric layer.

In such a case suitable materials for the dielectric layer are polyimide, silicon oxide or oxynitride films, or combinations thereof.

Alternatively the dielectric layer may be formed of pyroelectric material with each said region of pyroelectric material forming part of the dielectric layer, the elements of the array being defined by the positions of the first and second electrodes.

Thus the need for separate pyroelectric regions which must be attached to the dielectric layer is obviated.

Suitable pyroelectric materials for use in a thermal imaging device in accordance with the invention include pyroelectric polymers such as polyvinylidene fluoride (PVDF), or a copolymer thereof such as vinylidene fluoride/trifluoroethylene P(VDF/TrFE)). Other suitable pyroelectric materials include various ferroelectric liquid crystal polymers, and thin-film ceramics prepared for example by sputtering or metal organic chemical vapour deposition (MOCVD). Examples of such ceramic materials include lead lanthanum zirconium titanate (PLZT), lead zirconium titanate (PZT), lead titanate (PbTiO$_3$) and barium titanate (BaTiO$_3$).

Where the pyroelectric material is an organic material, preferably the regions will be less than 5 microns thick. Where the pyroelectric material is an inorganic material, preferably the regions will be less than 15 microns thick.

According to a second aspect of the present invention a process for making a thermal imaging device comprises: forming a support layer; forming a first electrically conductive layer on the support layer; forming a pyroelectric layer on the first electrically conductive layer by a thin film deposition technique; forming a second electrically conductive layer on the pyroelectric layer; defining discrete pyroelectric detector elements from the first and second electrically conductive layers and pyroelectric layer; and forming electrical connections from each detector element to a signal processing means.

The support layer may be a dielectric layer formed on a substrate, in which case the process includes the step of etching away part of the substrate to form a support structure for the dielectric layer. Alternatively, the support layer is a substrate, in which case the process includes the step of etching away at least part of the substrate.

It will be seen that by the use of such thin film deposition, techniques to produce the pyroelectric regions, processing of the thermal imaging device is made simpler and cheaper, and a higher yield is achieved as the requirement for machining brittle ceramic materials is avoided.

Furthermore in a device in accordance with the invention the thermal mass of each detector element is reduced, thus reducing hysteresis effects. Thermal cross-talk between the detector elements is also reduced.

One thermal imaging device in accordance with the invention together with a process for making the device will now be described by way of example only, with reference to the accompanying drawings of which:

Figure 1 shows is a schematic sectional view of the thermal imaging device; and

Figures 2 and 3 show two stages in the process for making the thermal imaging device shown in Figure 1.

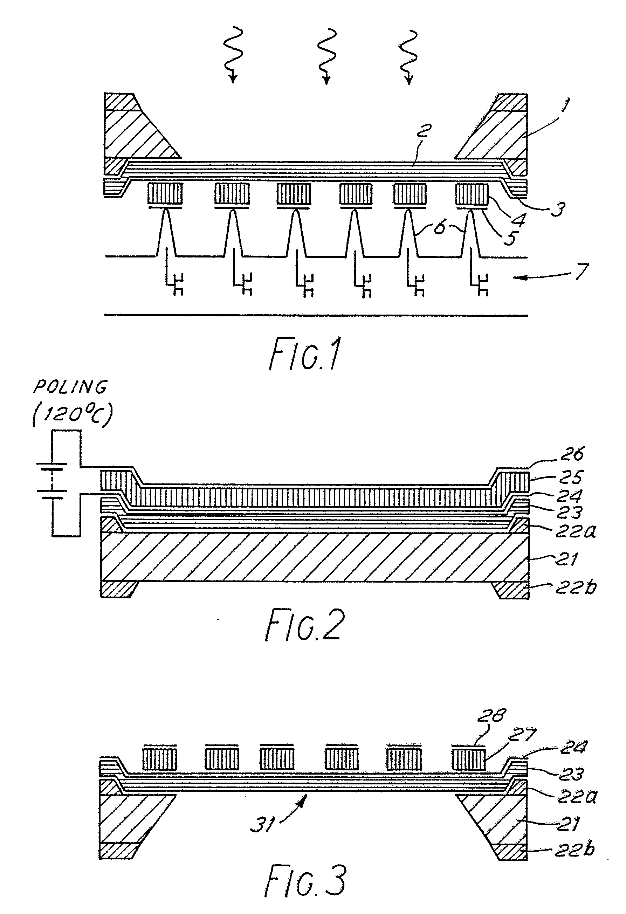

In the embodiment shown in Figure 1, a silicon ring or frame 1 supports a polyimide film 2 having a continuous gold electrode 3 on one surface. Discrete pyroelectric elements 4 are formed on the gold electrode 3 and respective gold electrodes 5 are formed on each of the pyroelectric elements 4. Electrically conductive, thermally insulative pillars 6 are formed at the inputs to an integrated circuit 7 arranged to process the outputs from the pyroelectric elements 4. The insulative pillars are also attached to respective gold surfaces 5 on the elements 4.

A process for making a thermal imaging device according to the invention as shown in Figures 2 and 3 includes the following steps:

1. A silicon wafer 21 is coated with silicon dioxide 22a, 22b (e.g. by thermal oxidation), and the silicon dioxide is etched away where the membrane is to be formed on the back side only or on both sides of the wafer.

2. Polyimide precursor is spin-coated on the wafer to the desired thickness, and heat treated to crosslink (cure) it and thus form a thin film (e.g. 600 nm thick) of polyimide 23.

3. A thin layer (e.g. 3O nm thick) of gold 24 is deposited on to the polyimide by thermal evaporation or by sputtering. This layer may be etched to create a pattern that reduces transverse heat conduction yet maintains electrical conduction.

4. The pyroelectric layer 25 in the form of a thin film, that is, up to 20 microns thick is deposited on to the gold layer, by whatever method is appropriate to that particular material. Examples, of suitable methods are spin-coating for polymeric type materials, sputtering or MOCVD for ceramic type materials, or Langmuir Blodgett monolayer deposition by known L.B. dipping techniques for Langmuir Blodgett films. Where the pyroelectric layer is a spin-coated polymer, the layer will typically be 1 micron thick, and will be made pyroelectric by any standard technique, for example Corona poling..

5. A second layer of gold 26 (e.g. 30 nm thick) is deposited on top of the pyroelectric layer to cap it (see Figure 2). The thickness of this layer can be selected and formed according to requirements; use of solder-bump bonding would require a thick layer (e.g. 1 micron) whereas a thin layer (30 nm) would possess a smaller thermal mass and provide a more rapid thermal response if used in conjunction with non-solder bump technology (e.g. thermo-compression bonding or conductive adhesive ink).

6. The top layer of gold and the underlying pyroelectric layer are etched away to create discrete pyroelectric elements 27 each having a gold electrode 28. The etch may be effected either by a plasma technique or a wet technique appropriate to the materials, or a combination thereof.

7. The silicon wafer is back-etched using an anisotropic etch to leave just the polyimide (or polyimide/$SiO_2$) membrane supporting the array of pyroelectric mesas (see Figure 3).

8. The whole device is then inverted (see Figure 1) onto a substrate on which has been formed a complementary matrix of thermally insulating pillars, each connected to charge-measuring circuitry. Each individual element forms a pixel which is thermally- and electrically-isolated from its neighbours except for one common, shared electrical connection, which may be patterned in a way to reduce thermal conduction.

It is advantageous to have an infra-red absorption layer in the detector array.. An absorption layer can be obtained either by partially oxidising the gold layer 24 before deposition of the pyroelectric layer 25, or by doping the pyroelectric layer 25 with a suitable infrared absorbing dye, or by depositing a layer of black gold or black platinum (partially oxidised gold or platinum) on the polyimide film 23 on the surface 31 remote from the pyroelectric elements 27.

Alternatively, the pixels can be formed so as to provide metal-dielectric-metal sandwich structures as disclosed in "Infrared Absorption of Three-layer Films" by P.A. Silberg, (J. Opt. Soc. Am., 47, 575 (1957), whereby the prime requirements are a reflective lower metal electrode (i.e. a thick gold film) and an upper metal electrode having a sheet resistivity of 377 ohms per square or thereabouts (e.g. a thin NiCr film), the pixels being dimensioned so as to induce interference effects in the incident infra-red radiation.

The electrically conductive, thermally insulative pillars 29 may comprise either a polymer pillar carrying an electrically conductive track down its side, or a metal pillar with a thermal isolation region, for example, a long, thin, narrow electrical conductor to the track. These pillars may be coated with a low melting point solder on the top surface for attachment to the gold electrodes 28 on the surfaces of the pyroelectric elements 29.

Instead of using a polyimide film to form the supportive membrane, a silicon dioxide ($SiO_2$), silicon nitride ($Si_3N_4$) or silicon oxynitride film can be formed on the silicon substrate 21. The successive processing steps are carried out as before. Alternatively, a composite polyimide-silicon oxide, nitride or oxynitride film can be employed.

It will be appreciated that whilst in the particular device described herebefore by way of example, an array of pyroelectric mesas are supported on a polyimide membrane, an alternative arrangement is where the supporting membrane is itself made from a pyroelectric material such as P (VDF/TrFE). In such a device the substrate 1 will generally be directly coated with pyroelectric material, the substrate being subsequently etched away to leave a film of pyroelectric maerial. An electrically conductive layer, constituting the inter-connected electrodes 24 for the pyroelectric detector element array may then be formed on the exposed surface of the pyroelectric layer, the inter-connected electrodes and pattern of discrete electrodes formed on the other surface of the pyroelectric layer together defining an array of discrete pyroelectric detector elements.

## Claims

1. A thermal imaging device comprising: a thermally insulative dielectric layer; an array of discrete pyroelectric detector elements carried by the dielectric layer, each detector element comprising a region of pyroelectric material and first and second electrodes each carried on respective oppositely directed surfaces of the region; and means for transferring electrical signals between the detector elements and a signal processing means.

2. A device according to Claim 1 in which the regions are in the form of thin films.

3. A device according to Claim 2 in which the regions are formed from an organic material, and are less than 5 microns thick.

4. A device according to any one of the preceding claims in which the regions are formed of a pyroelectric polymer.

5. A device according to Claim 4 in which the polymer is polyvinylidene fluoride or a copolymer thereof.

6. A device according to Claim 2 in which the regions are formed from an inorganic material produced by a thin film deposition technique, the regions being less than 15 microns thick.

7. A device according to any one of the preceding claims in which each region of pyroelectric material is distinct from the dielectric layer.

8. A device according to Claim 7 in which the dielectric layer is supported at its edges.

9. A device according to Claim 7 or Claim 8 in which the dielectric layer comprises a polyimide, silicon oxide, or oxynitride film or a combination thereof.

10. A device according to any one of Claims 1 to 6 in which the dielectric layer is formed of a pyroelectric material, each said region of pyroelectric material forming part of the dielectric layer, the elements of the array being defined by the positions of the first and second electrodes.

11. A device according to any one of the preceding claims in which the means for transferring electrical signals comprises a plurality of pillars each effective to provide an electrical path between a detector element and the signal processing means, each pillar also being effective to support the layer.

12 A device according to any one of the preceding claims in which one of the first and second electrodes forms part of a continuous electrode electrically connecting all the detector elements of the array.

13. A device according to any one of the preceding claims in which each detector element includes an infra-red absorber effective to increase the amount of infra-red radiation absorbed by each detector element.

14. A device according to Claim 13 in which the absorber is an infra-red absorbant layer carried on the dielectric layer.

15. A device according to Claim 13 in which each detector element is constructed and dimensioned so as to produce interference effects in the incident infra-red radiation thereby increasing absorption of the radiation.

16. A process for making a thermal imaging device comprising: forming a support layer; forming a first electrically conductive layer on the support layer; forming a pyroelectric layer on the first electrically conductive layer by a thin film deposition technique; forming a second electrically conductive layer on the pyroelectric layer; defining discrete pyroelectric detector elements from the first and second electrically conductive layers and pyroelectric layer; and forming electrical connections from each detector element to a signal processing means.

17. A process according to Claim 16 in which the pyroelectric layer is formed from a pyroelectric polymer, and the deposition technique is a spin-coating process.

18. A process according to Claim 16 in which the pyroelectric layer is formed from a ceramic material and the deposition technique is sputtering.

19. A process according to Claim 16 in which the pyroelectric layer is formed from a ceramic material, and the deposition technique is metal-organic chemical vapour deposition.

20. A process according to Claim 16 in which the pyroelectric layer is formed from a Langmuir-Blodgett film, and the deposition technique is a Langmuir-Blodgett technique.

21. A process according to any one of Claims 16 to 20 in which the support layer is a dielectric layer formed on a silicon substrate, the process including the step of etching away part of the substrate to form a support structure for the dielectric layer.

22. A process according to any one of Claims 16 to 20 in which the support layer is a substrate, the process including the step of etching away at least part of the substrate.

FIG.1

POLING
(120°C)

FIG.2

FIG.3